# EUROPEAN PATENT APPLICATION

(11) **EP 3 933 256 A1**
(43) Date of publication of application: **05.01.2022**
(21) Application number: 20763428.8
(22) Date of filing: 28.02.2020
(51) Int. Cl.: F21S 2/00, F21L 4/00, F21V 9/38, G02B 5/20, H01L 33/00, H01L 33/50, F21W 131/40, F21Y 115/10

(54) **LIGHT EMITTING DEVICE AND ILLUMINATION DEVICE**

(30) Priority: 28.02.2019 JP 2019035200; 28.03.2019 JP 2019064769
(71) Applicant: Kyocera Corporation, Kyoto-shi, Kyoto 612-8501 (JP)
(72) Inventor: HIRABAYASHI, Tsuneyuki, Kyoto-shi, Kyoto 612-8501 (JP); KATOU, Hidetaka, Kyoto-shi, Kyoto 612-8501 (JP); KUSANO, Tamio, Kyoto-shi, Kyoto 612-8501 (JP); MIYAKE, Akira, Kyoto-shi, Kyoto 612-8501 (JP); KOHEI, Ikeda, Kyoto-shi, Kyoto 612-8501 (JP)
(74) Representative: Viering, Jentschura & Partner mbB Patent- und Rechtsanwälte
(86) International application number: PCT/JP2020/008543
(87) International publication number: WO 2020/175710

(57) **Abstract**

A light emitting device emits light that is specified by an emission spectrum having a first peak wavelength, a second peak wavelength, a third peak wavelength, and a fourth peak wavelength. The first peak wavelength is included in a wavelength range of 600 nm to 660 nm. The second peak wavelength is included in a wavelength range of 510 nm to 550 nm. The third peak wavelength is included in a wavelength range of 440 nm to 470 nm. The fourth peak wavelength is included in a wavelength range of 360 nm to 430 nm. When a light intensity at the first peak wavelength is assumed to be 1, a relative light intensity at the second peak wavelength is greater than or equal to 0.75 and less than or equal to 0.98. A relative light intensity at the third peak wavelength is greater than or equal to 0.55 and less than or equal to 0.95. A relative light intensity at the fourth peak wavelength is greater than or equal to 0.50 and less than or equal to 0.85.

## Description

### Cross-References to Related Applications

The present application claims priority of Japanese Patent Application No. 2019-35200, filed on February 28, 2019, and Japanese Patent Application No. 2019-64769, filed on March 28, 2019, the entire contents of each of which are incorporated herein by reference.

### Technical Field

The present disclosure relates to a light emitting device and an illumination apparatus.

### Background Art

Illumination apparatuses for displaying a food, such as meat, placed in a showcase of a store in a favorable color are known (see, for example, PTL 1).

### Citation List

### Patent Literature

PTL 1: Japanese Unexamined Patent Application Publication No. 2012-15471

### Summary of Invention

A light emitting device according to an embodiment of the present disclosure emits light that is specified by an emission spectrum having a first peak wavelength, a second peak wavelength, a third peak wavelength, and a fourth peak wavelength. The first peak wavelength is included in a wavelength range of 600 nm to 660 nm. The second peak wavelength is included in a wavelength range of 510 nm to 550 nm. The third peak wavelength is included in a wavelength range of 440 nm to 470 nm. The fourth peak wavelength is included in a wavelength range of 360 nm to 430 nm. When a light intensity at the first peak wavelength is assumed to be 1, a relative light intensity at the second peak wavelength is greater than or equal to 0.75 and less than or equal to 0.98. When the light intensity at the first peak wavelength is assumed to be 1, a relative light intensity at the third peak wavelength is greater than or equal to 0.55 and less than or equal to 0.95. When the light intensity at the first peak wavelength is assumed to be 1, a relative light intensity at the fourth peak wavelength is greater than or equal to 0.50 and less than or equal to 0.85.

A light emitting device according to an embodiment of the present disclosure emits light that is specified by an emission spectrum having a first peak wavelength, a second peak wavelength, and a third peak wavelength. The first peak wavelength is included in a wavelength range of 600 nm to 660 nm. The second peak wavelength is included in a wavelength range of 440 nm to 470 nm. The third peak wavelength is included in a wavelength range of 360 nm to 430 nm. When a light intensity at the first peak wavelength is assumed to be 1, a relative light intensity at the second peak wavelength is greater than or equal to 0.15 and less than or equal to 0.35. When the light intensity at the first peak wavelength is assumed to be 1, a relative light intensity at the third peak wavelength is greater than or equal to 0.2 and less than or equal to 0.5.

An illumination apparatus according to an embodiment of the present disclosure includes at least one light emitting device described above.

### Brief Description of Drawings

[Fig. 1] Fig. 1 illustrates an example in which an illumination apparatus according to an embodiment is used for meat inspection.
[Fig. 2] Fig. 2 illustrates an example of a light emitting device according to an embodiment.
[Fig. 3] Fig. 3 is a sectional view of the light emitting device illustrated in Fig. 2, taken along line A-A.
[Fig. 4] Fig. 4 is an enlarged view of the light emitting device illustrated in Fig. 3.
[Fig. 5] Fig. 5 illustrates an example of an emission spectrum of a light emitting element of the light emitting device according to the embodiment.
[Fig. 6] Fig. 6 illustrates an example of a fluorescence spectrum of each of a first phosphor, a second phosphor, and a third phosphor of the light emitting device according to the embodiment.
[Fig. 7] Fig. 7 illustrates an example of an emission spectrum when color temperature is constant.
[Fig. 8] Fig. 8 illustrates an example of the relationship between a test color and a color rendering index.
[Fig. 9] Fig. 9 illustrates an example of an emission spectrum when color temperature differs.
[Fig. 10A] Fig. 10A is an example of a top view of the illumination apparatus according to the embodiment.
[Fig. 10B] Fig. 10B is an example of a side view of the illumination apparatus according to the embodiment.
[Fig. 11] Fig. 11 illustrates an example in which the illumination apparatus according to the embodiment is used for fresh fish inspection.
[Fig. 12] Fig. 12 illustrates an example of an emission spectrum when a color temperature is constant.
[Fig. 13] Fig. 13 illustrates an example of the relationship between a test color and a color rendering index.
[Fig. 14] Fig. 14 illustrates an example of an emission spectrum when a color temperature differs.
[Fig. 15] Fig. 15 is an example of a side view of an illumination apparatus according to an embodiment. Description of Embodiments

Food such as meat or fresh fish may be illuminated for inspection. There is a demand for an apparatus that can illuminate food in such a way that the accuracy in inspection of the food can be increased.

Hereafter, a light emitting device according to an embodiment and an embodiment of an illumination apparatus will be described with reference to the drawings.

### (Embodiment related to Meat Inspection)

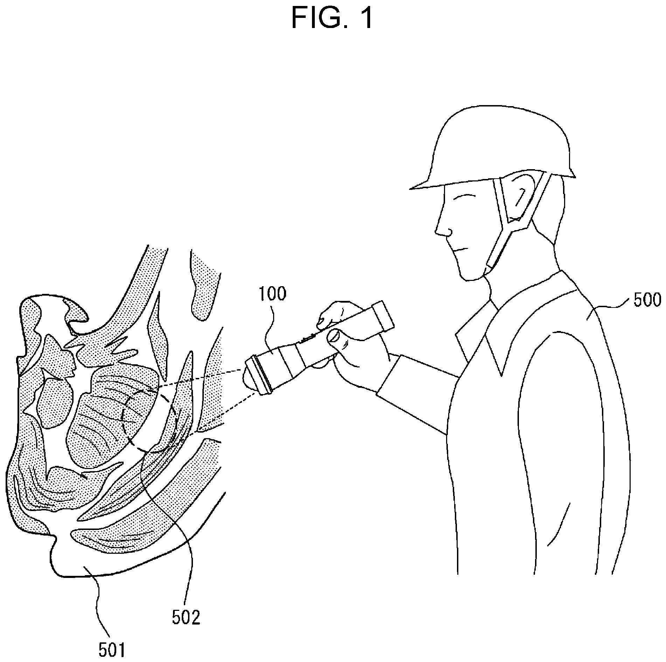

As illustrated in Fig. 1, for example, in order to perform grading of meat 501, a user 500 illuminates the meat 501 by using an illumination apparatus 100 and inspects the meat 501. The user 500 may be, for example, a grader of the Japan Meat Grading Association. The term "grading" of the meat 501 refers to evaluation of the meat 501 by the user 500. Evaluation of the meat 501 is performed based on, for example, the following factors: the breed of the meat 501; the sex of the meat 501; the grade of the meat 501 (A5 to A1, B5 to B1, C5 to C1, or the like); and marbling of fat, the luster of red meat, the firmness or fineness of red meat, the color or quality of fat, and the like of the meat 501.

When inspecting the meat 501, the user 500 irradiates an irradiation region 502 by using the illumination apparatus 100 to inspect mainly a red portion called "red meat" and a white portion called "marbling". The user 500 can inspect the meat 501 with high accuracy by irradiating the meat 501 with light of the illumination apparatus 100.

### <Configuration of Light Emitting Device>

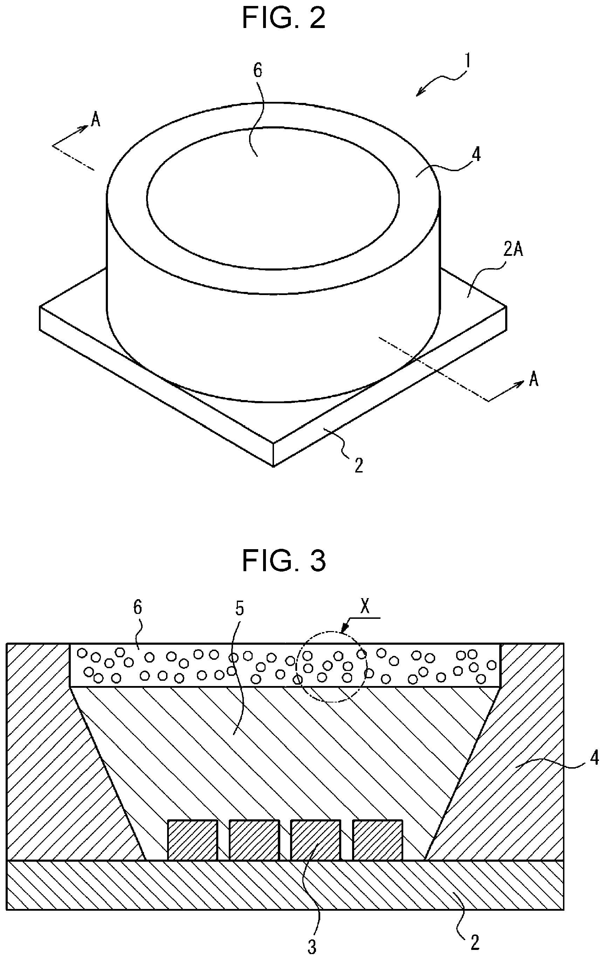

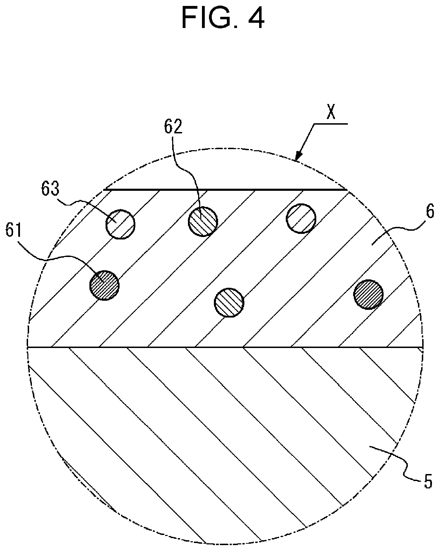

Referring to Figs. 2, 3, and 4, a light emitting device 1 according to the present embodiment will be described in detail. The aforementioned illumination apparatus 100 is equipped with at least one light emitting device 1.

The light emitting device 1 includes an element substrate 2, a plurality of light emitting elements 3, a frame 4, a sealing member 5, and a wavelength conversion member 6.

The element substrate 2 may be made of, for example, an insulating material. The element substrate 2 may be made of, for example, a ceramic material such as alumina or mullite, a glass ceramic material, or a composite material in which one or more of these materials are mixed. The element substrate 2 may be made of a polymer material in which metal oxide particles that can adjust thermal expansion are dispersed.

The element substrate 2 may include a wiring conductor that electrically connects the element substrate 2 to a wiring substrate 30, on a main surface 2A of the element substrate 2 or in the element substrate 2. The wiring conductor may be made of, for example, a conductive material such as tungsten, molybdenum, manganese, or copper. The wiring conductor may be made by, for example: printing a predetermined pattern on a ceramic green sheet, which is to become the element substrate 2, by using a metal paste in which an organic solvent is added to tungsten powder; stacking a plurality of the ceramic green sheets; and firing the ceramic green sheets. In order to prevent oxidation of the wiring conductor, for example, a plating layer of nickel, gold, or the like may be formed on the surface of the wiring conductor.

The element substrate 2 may include a metal reflection layer, which is spaced apart from each of the wiring conductor and the plating layer, in order that light emitted by the light emitting elements 3 can be efficiently directed to the outside. The metal reflection layer may be made of, for example, a metal material such as aluminum, silver, gold, copper, or platinum.

The plurality of light emitting elements 3 are mounted on the main surface 2A of the element substrate 2. The plurality of light emitting elements 3 are electrically connected to a plating layer of the element substrate 2, which is affixed to a surface of a wiring conductor, via, for example, a brazing alloy or solder. The number of the light emitting elements 3 mounted on the main surface 2A of the element substrate 2 is not particularly limited.

The light emitting element 3 is, for example, a light emitting diode (LED). The LED emits light to the outside as an electron and a positive hole recombine in a P-N junction where a P-type semiconductor and an N-type semiconductor are joined. The light emitting element 3 is not limited to a LED and may be another light emitting device such as a laser diode (LD).

The light emitting element 3 may include a light-transmitting base and an optical semiconductor layer formed on the light-transmitting base. The light-transmitting base includes, for example, a material with which it is possible to grow an optical semiconductor layer thereon by using a chemical vapor deposition method such as a metal-organic vapor phase epitaxy (MOVPE) method or a molecular beam epitaxy method. The light-transmitting base may be made of, for example, sapphire, gallium nitride, aluminum nitride, zinc oxide, zing selenide, silicon carbide, silicone, or zirconium diboride. The thickness of the light-transmitting base may be, for example, greater than or equal to 50 µm and less than or equal to 1000 µm.

The optical semiconductor layer may include a first semiconductor layer formed on the light-transmitting base, a light emitting layer formed on the first semiconductor layer, and a second semiconductor layer formed on the light emitting layer. The first semiconductor layer, the light emitting layer, and the second semiconductor layer may be made of, for example, a group III nitride semiconductor, a group III-V nitride semiconductor such as gallium phosphide or gallium arsenide, or a group III nitride semiconductor such as aluminum nitride or indium nitride.

The thickness of the first semiconductor layer may be, for example, greater than or equal to 1 µm and less than or equal to 5 µm. The thickness of the light emitting layer may be, for example, greater than or equal to 25 nm and less than or equal to 150 nm. The thickness of the second semiconductor layer may be, for example, greater than or equal to 50 nm and less than or equal to 600 nm.

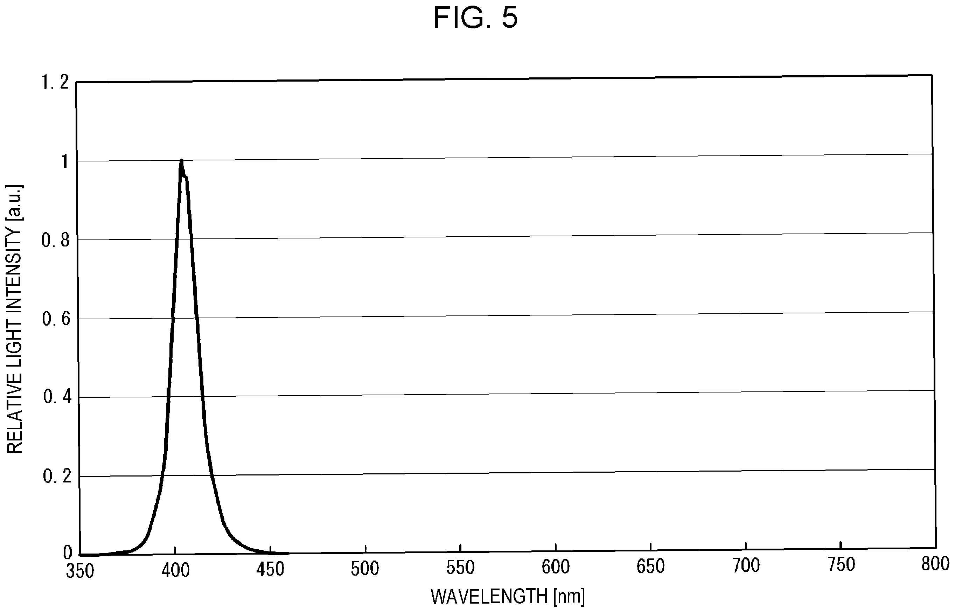

Fig. 5 illustrates an example of an emission spectrum of the light emitting element 3. In the graph of Fig. 5, the horizontal axis and the vertical axis respectively represent the wavelength and the relative light intensity of light emitted by the light emitting element 3. The relative light intensity is the ratio of light intensity to light intensity at a peak wavelength when the light intensity at the peak wavelength is assumed to be 1. According to the graph of Fig. 5, the light emitting element 3 emits light having a peak wavelength in a wavelength range of 360 nm to 430 nm. The wavelength range of 360 nm to 430 nm is included in the visible light range. The wavelength range of 360 nm to 430 nm is also called a purple light range.

The frame 4 may be made of, for example, a ceramic material such as aluminum oxide, titanium oxide, zirconium oxide, or yttrium oxide. The frame 4 may be made of a porous material. The frame 4 may be made of a resin material in which powders including metal oxides such as aluminum oxide, titanium oxide, zirconium oxide, and yttrium oxide are mixed. The material of the frame 4 is not limited to these and may be any appropriate material.

The frame 4 is connected to the main surface 2A of the element substrate 2 via, for example, a resin, a brazing alloy, or solder. The frame 4 is disposed on the main surface 2A of the element substrate 2 to be spaced apart from the plurality of light emitting elements 3 in such a way as to surround the plurality of light emitting elements 3. The frame 4 is disposed in such a way that an inner wall surface thereof expands outward with increasing distance from the main surface 2A of the element substrate 2. The inner wall surface functions as a reflection surface that reflects light emitted by the plurality of light emitting elements 3. The inner wall surface may include, for example, a metal layer that is made of a metal material such as tungsten, molybdenum, or manganese, and a plating layer that covers the metal layer and that is made of a metal material such as nickel or gold. The plating layer reflects light emitted by the plurality of light emitting elements 3.

The shape of the inner wall surface of the frame 4 may be a circular shape in plan view. When the shape of the inner wall surface is a circular shape, the frame 4 can substantially uniformly reflect outward the light emitted by the plurality of light emitting elements 3. The inclination angle of the inner wall surface of the frame 4 may be set, for example, to be greater than or equal to 55 degrees and less than or equal to 70 degrees with respect to the main surface 2A of the element substrate 2.

An inner space surrounded by the element substrate 2 and the frame 4, excluding an upper part of an inner space surrounded by the frame 4, is filled with the sealing member 5. The sealing member 5 seals the plurality of light emitting elements 3, and transmits light emitted by the plurality of light emitting elements 3. The sealing member 5 may be made of, for example, a light-transmitting material. The sealing member 5 may be made of, for example, a light-transmitting insulating resin such as silicone resin, acrylic resin, or epoxy resin; or a light-transmitting glass material. The refractive index of the sealing member 5 may be set, for example, to be greater than or equal to 1.4 and less than or equal to 1.6.

The wavelength conversion member 6 includes a first phosphor that converts light having a peak wavelength in a wavelength range of 360 nm to 430 nm into light having a peak wavelength in a wavelength range of 600 nm to 660 nm. The wavelength conversion member 6 includes a second phosphor that converts light having a peak wavelength in a wavelength range of 360 nm to 430 nm into light having a peak wavelength in a wavelength range of 530 nm to 560 nm. The wavelength conversion member 6 includes a third phosphor that converts light having a peak wavelength in a wavelength range of 360 nm to 430 nm into light having a peak wavelength in a wavelength range of 440 nm to 470 nm.

The wavelength conversion member 6 is disposed at a position where the wavelength conversion member 6 can convert light emitted by the light emitting elements 3 into light having a peak wavelength in a wavelength range of 600 nm to 660 nm, light having a peak wavelength in a wavelength range of 530 nm to 560 nm, and light having a peak wavelength in a wavelength range of 440 nm to 470 nm. In the example illustrated in Figs. 2, 3, and 4, the wavelength conversion member 6 is disposed in an upper part of the inner space surrounded by the element substrate 2 and the frame 4 along the upper surface of the sealing member 5. The position of the wavelength conversion member 6 is not limited to this example, and, for example, the wavelength conversion member 6 may be disposed in such a way as to protrude from the upper part of the inner space surrounded by the element substrate 2 and the frame 4.

The wavelength conversion member 6 includes a light-transmitting member, a first phosphor 61, a second phosphor 62, and a third phosphor 63. The wavelength conversion member 6 is formed by incorporating the first phosphor 61, the second phosphor 62, and the third phosphor 63 in the light-transmitting member. The amounts of the phosphors included in the light-transmitting member are appropriately set. The first phosphor 61, the second phosphor 62, and the third phosphor 63 are substantially uniformly dispersed in the light-transmitting member. Light emitted by the light emitting elements 3 enters the inside of the wavelength conversion member 6 via the sealing member 5.

The light-transmitting member may be made of, for example, a light-transmitting insulating resin such as fluorocarbon resin, silicone resin, acrylic resin, or epoxy resin; or a light-transmitting glass material.

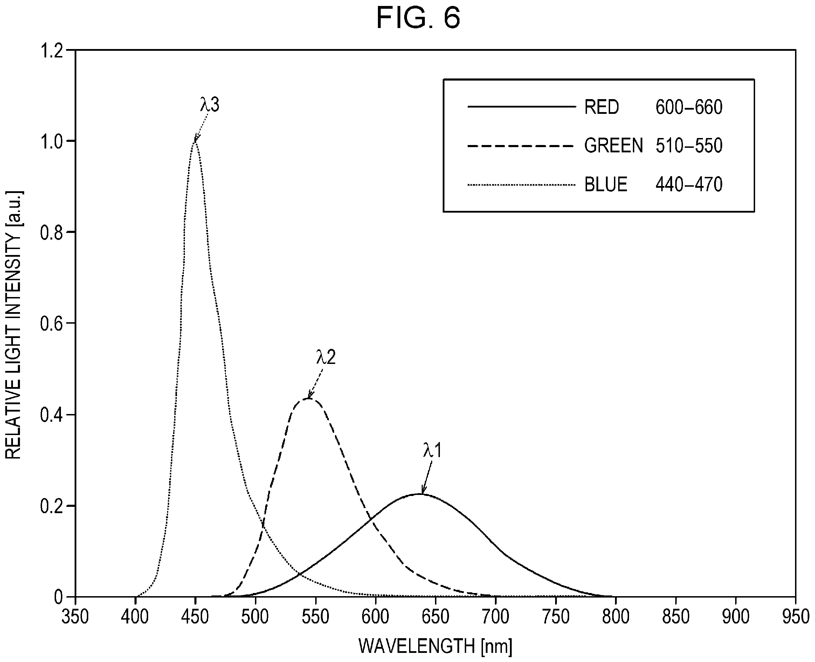

Fig. 6 illustrates an example of a fluorescence spectrum of a phosphor. In the graph of Fig. 6, the horizontal axis and the vertical axis respectively represent the wavelength and the relative light intensity of light emitted by the phosphor.

The phosphor may include the first phosphor 61 having a first peak wavelength λ1 in a wavelength range of 600 nm to 660 nm as illustrated in Fig. 6. The first phosphor 61 is, for example, a phosphor that exhibits red. As the first phosphor 61, for example, Y₂O₂S:Eu, Y₂O₃:Eu, SrCaClAlSiN₃:Eu²⁺, CaAlSiN₃:Eu, CaAlSi(ON)₃:Eu, or the like may be used. The first phosphor 61 converts light that has entered the wavelength conversion member 6 into light having the first peak wavelength λ1 in the wavelength range of 600 nm to 660 nm, and emits the converted light.

The phosphor may include the second phosphor 62 having a second peak wavelength λ2 in a wavelength range of 510 nm to 550 nm as illustrated in Fig. 6. The second phosphor 62 is, for example, a phosphor that exhibits green. As the second phosphor 62, for example, SrSi₂(O,Cl)₂N₂:Eu, (Sr,Ba,Mg)₂SiO₄:Eu²⁺, ZnS:Cu, Al, Zn₂SiO₄:Mn, or the like may be used. The second phosphor 62 converts light that has entered the wavelength conversion member 6 into light having the second peak wavelength λ2 in the wavelength range of 530 nm to 560 nm, and emits the converted light.

The phosphor may include the third phosphor 63 having a third peak wavelength λ3 in a wavelength range of 440 nm to 470 nm as illustrated in Fig. 6. The third phosphor 63 is, for example, a phosphor that exhibits blue. As the third phosphor 63, for example, BaMgAl₁₀O₁₇:Eu, (Sr,Ca,Ba)₁₀(PO₄)₆C₁₂:Eu, (Sr,Ba)₁₀(PO₄)₆C₁₂:Eu, or the like may be used. The third phosphor 63 converts light that has entered the wavelength conversion member 6 into light having the third peak wavelength λ3 in the wavelength range of 440 nm to 470 nm, and emits the converted light.

The wavelength conversion member 6 may include, in addition to the first phosphor 61, the second phosphor 62, the third phosphor 63, for example, a phosphor that exhibits blue-green and that has a peak wavelength in a wavelength range of 450 nm to 550 nm. Examples of a phosphor that exhibits blue-green include (Sr,Ba,Ca)₅(PO₄)₃Cl:Eu and Sr₄Al₁₄O₂₅:Eu. The wavelength conversion member 6 may include, in addition to the first phosphor 61, the second phosphor 62, and the third phosphor 63, for example, a phosphor that exhibits a color in a near-infrared range and that has a peak wavelength in a wavelength range of 680 nm to 800 nm. Examples of a phosphor that exhibits a color in the near-infrared range include 3Ga₅O₁₂:Cr.

### <Emission Spectrum of Light Emitting Device>

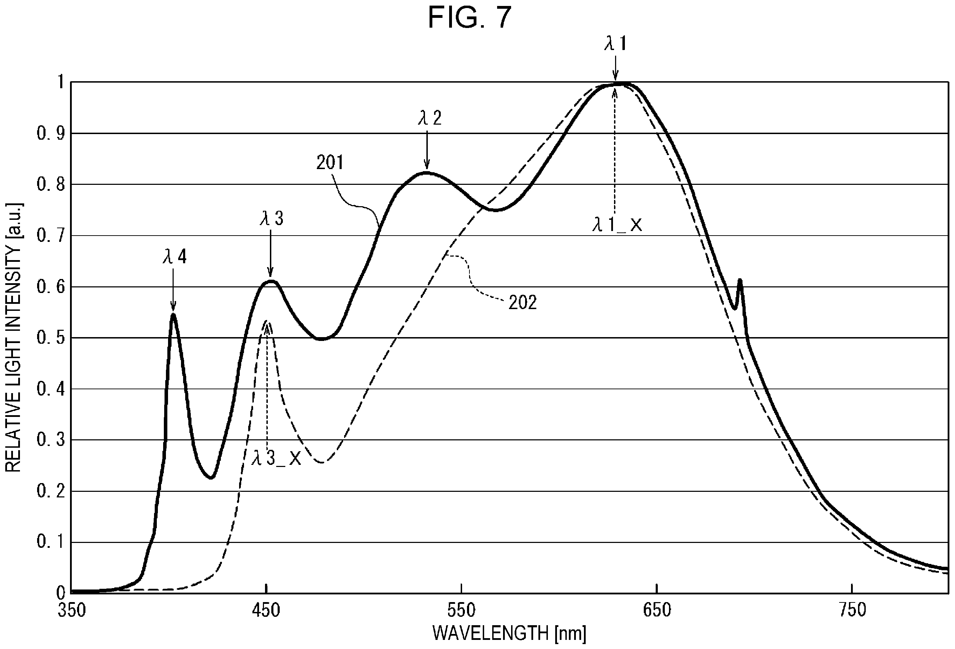

Referring to Fig. 7, an emission spectrum 201 of the light emitting device 1 according to the present embodiment and an emission spectrum 202 of a light emitting device according to a comparative example will be described. The emission spectra are measured, for example, by spectroscopy using a spectrophotometry device or the like. In the graph of Fig. 7, the horizontal axis and the vertical axis respectively represent the wavelength and the relative light intensity of light emitted by the light emitting device 1.

The light emitting device 1 emits light in which light emitted by the first phosphor 61, light emitted by the second phosphor 62, light emitted by the third phosphor 63, and light emitted by the plurality of light emitting elements 3 are synthesized in a wavelength range of 360 nm to 780 nm.

As illustrated in Fig. 7, the emission spectrum 201 has a first peak wavelength λ1 in a wavelength range of 600 nm to 660 nm. The first peak wavelength λ1 corresponds to the wavelength of light emitted by the first phosphor 61. The emission spectrum 201 has a second peak wavelength λ2 in a wavelength range of 510 nm to 550 nm. The second peak wavelength λ2 corresponds to the wavelength of light emitted by the second phosphor 62. The emission spectrum 201 has a third peak wavelength λ3 in a wavelength range of 440 nm to 470 nm. The third peak wavelength λ3 corresponds to the wavelength of light emitted by the third phosphor 63. The emission spectrum 201 has a fourth peak wavelength λ4 in a wavelength range of 360 nm to 430 nm. That is, the emission spectrum 201 has four peak wavelengths.

In the emission spectrum 201, when the light intensity at the first peak wavelength λ1 is assumed to be 1, the relative light intensity at the second peak wavelength λ2 is greater than or equal to 0.75 and less than or equal to 0.98. In the emission spectrum 201, when the light intensity at the first peak wavelength λ1 is assumed to be 1, the relative light intensity at the third peak wavelength λ3 is greater than or equal to 0.55 and less than or equal to 0.95. In the emission spectrum 201, the relative light intensity at the fourth peak wavelength λ4 is greater than or equal to 0.50 and less than or equal to 0.85.

On the other hand, the light emitting device according to the comparative example emits light in which light emitted by a predetermined phosphor and light emitted by a plurality of predetermined light emitting devices are synthesized in a wavelength range of 360 nm to 780 nm. The predetermined phosphor is, for example, a first phosphor having a first peak wavelength λ1_X in a wavelength range of 600 nm to 660 nm. The first phosphor converts light that has entered a wavelength conversion member into light having the first peak wavelength λ1_X in the wavelength range of 600 nm to 660 nm, and emits the converted light. The predetermined light emitting device is, for example, a light emitting device that emits light having a third peak wavelength λ3_X in a wavelength range of 440 nm to 470 nm (so-called blue excitation light).

As illustrated in Fig. 7, the emission spectrum 202 of the comparative example has the first peak wavelength λ1_X in the wavelength range of 600 nm to 660 nm and the third peak wavelength λ3_X in the wavelength range of 440 nm to 470 nm. That is, the emission spectrum 202 has two peak wavelengths.

The light emitting device 1 according to the present embodiment emits light that is specified by the emission spectrum 201 having the first peak wavelength λ1 in the wavelength range of 600 nm to 660 nm. The light emitting device 1 emits light that is specified by the emission spectrum 201 having the second peak wavelength λ2 in the wavelength range of 510 nm to 550 nm. The light emitting device 1 emits light that is specified by the emission spectrum 201 having the third peak wavelength λ3 in the wavelength range of 440 nm to 470 nm. The light emitting device 1 emits light that is specified by the emission spectrum 201 having the fourth peak wavelength λ4 in the wavelength range of 360 nm to 430 nm. When the light intensity at the first peak wavelength λ1 is assumed to be 1, the relative light intensity at the second peak wavelength λ2 is greater than or equal to 0.75 and less than or equal to 0.98. When the light intensity at the first peak wavelength λ1 is assumed to be 1, the relative light intensity at the third peak wavelength λ3 is greater than or equal to 0.55 and less than or equal to 0.95. When the light intensity at the first peak wavelength λ1 is assumed to be 1, the relative light intensity at the fourth peak wavelength λ4 is greater than or equal to 0.50 and less than or equal to 0.85. Light that is specified by the emission spectrum 201 include red light, green light, and blue light each with a proportion close to that of the spectrum of sunlight. Thus, it is possible to realize the light emitting device 1 that emits light in which light of all colors from blue to red are uniformly dispersed and that is close to sunlight.

### <Color Rendering Performance of Light Emitting Device>

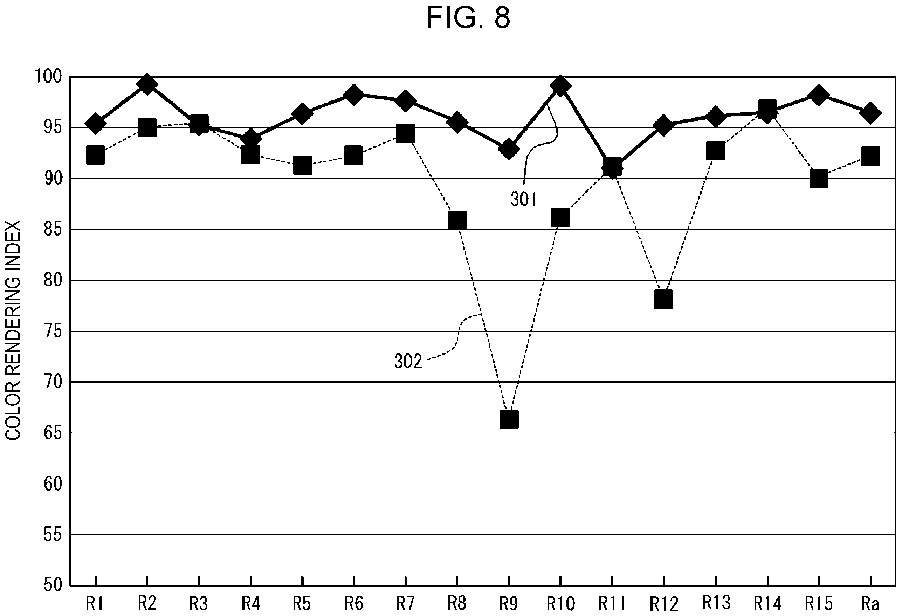

Next, referring to Fig. 8, the color rendering performance of the light emitting device 1 according to the present embodiment and the color rendering performance of the light emitting device according to the comparative example, which is shown by the emission spectrum 202, will be described. In the graph of Fig. 8, the horizontal axis and the vertical axis respectively represent a test color and a color rendering index. A graph 301 is a graph in which the values of the color rendering index of the light emitting device 1 for the test colors are plotted and connected by a solid line. A graph 302 is a graph in which the values of the color rendering index of the light emitting device according to the comparative example for the test colors are plotted and connected by a broken line.

The term "color rendering performance" refers to an indicator for evaluating the quality of a light source as to how a color looks with respect to natural light, and is numerically represented by a color rendering index. The color rendering index can be represented by an average color rendering index Ra, a special color rendering index R9, a special color rendering index R10, a special color rendering index R11, a special color rendering index R12, a special color rendering index R13, a special color rendering index R14, a special color rendering index R15, and the like. Examples of a light source having an average color rendering index Ra = 100 include the Sun and an incandescent lamp.

As illustrated in Fig. 8, in the graph 301, the average color rendering index Ra, the special color rendering index R9, the special color rendering index R10, the special color rendering index R11, the special color rendering index R12, the special color rendering index R13, the special color rendering index R14, and the special color rendering index R15 are all greater than or equal to 90. In the graph 302, the average color rendering index Ra is greater than or equal to 90. The special color rendering index R9 is about 65. The special color rendering index R10 is about 85. The special color rendering index R11 is greater than or equal to 90. The special color rendering index R12 is about 78. The special color rendering index R13 is greater than or equal to 90. The special color rendering index R14 is greater than or equal to 90. The special color rendering index R15 is about 90.

It can be seen from Fig. 8 that the color rendering indices of the light emitting device 1 for the test colors are all greater than or equal to 90 and have very small variation. In contrast, it can be seen that the color rendering indices of the light emitting device according to the comparative example for the test colors have values that are greater than or equal to 90 and values that are less than equal to 70 and have very large variation. Accordingly, it can be seen that the color rendering performance of the light emitting device 1 is higher than that of the light emitting device according to the comparative example.

The light emitting device 1 according to the present embodiment emits light having a special color rendering index R9 that is greater than or equal to 90, and emits light having a special color rendering index R12 that is greater than or equal to 90. Thus, it is possible to realize the light emitting device 1 having an average color rendering index Ra and special color rendering indices R9, R10, R11, R12, R13, R14, and R15 that are all greater than or equal to 90 and having high color rendering performance.

### <Color Temperature of Light Emitting Device>

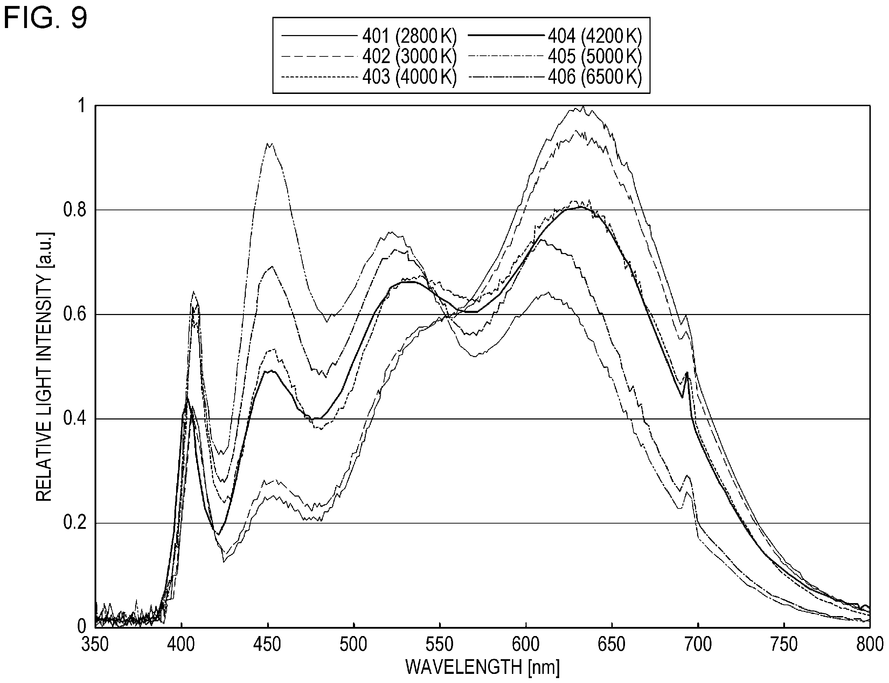

Next, referring to Fig. 9, the emission spectrum of the light emitting device when the color temperature differs will be described. The emission spectrum is measured, for example, by spectroscopy using a spectrophotometry device or the like. In the graph of Fig. 9, the horizontal axis and the vertical axis respectively represent the wavelength and the relative light intensity of light emitted by the light emitting device.

A color temperature is a value representing the color of light emitted by a light source and is represented by a unit called kelvin (K). A low color temperature means that the light source emits reddish light. A high color temperature means that the light source emits bluish light. For example, the color temperature of light emitted by an incandescent lamp is about 2800 K. For example, the color temperature of neutral light is about 4200 K.

Light that is specified by an emission spectrum 401 has a color temperature of 2800 K. Light that is specified by an emission spectrum 402 has a color temperature of 3000 K. Light that is specified by an emission spectrum 403 has a color temperature of 4000 K. Light that is specified by an emission spectrum 404 has a color temperature of 4200 K. Light that is specified by an emission spectrum 405 has a color temperature of 5000 K. Light that is specified by an emission spectrum 406 has a color temperature of 6500 K. The relative light intensity of each of the emission spectra 402, 403, 404, 405, and 406 is represented as the ratio of light intensity to light intensity at a peak wavelength when the light intensity of the emission spectrum 401 at the maximum peak wavelength is assumed to be 1.

It can be seen from Fig. 9 that the relative light intensity of the emission spectrum 401 in a wavelength range of 600 nm to 660 nm is very high and has a large variation compared with the relative light intensity in a wavelength range of 440 nm to 470 nm. It can be seen that red light is dominant in light having a color temperature of 2800 K.

It can be seen that the relative light intensity of the emission spectrum 402 in a wavelength range of 600 nm to 660 nm is very high and has a large variation compared with the relative light intensity in a wavelength range of 440 nm to 470 nm. It can be seen that red light is dominant in light having a color temperature of 3000 K.

It can be seen that the relative light intensity of the emission spectrum 406 in a wavelength range of 440 nm to 470 nm is very high and has a large variation compared with the relative light intensity in a wavelength range of 600 nm to 660 nm. It can be seen that blue light is dominant in light having a color temperature of 6500 K.

It can be seen that, in each of the emission spectra 403, 404, and 405, the difference between the relative light intensity in a wavelength range of 600 nm to 660 nm and the relative light intensity in a wavelength range of 440 nm to 470 nm is small and the relative light intensity has a small variation. It can be seen that light having a color temperature from 4000 K to 5000 K includes red light, green light, and blue light in a well-balanced manner.

It can be seen from Fig. 9 that the balance among the relative light intensities of red light, green light, and blue light is not good in each of the emission spectrum 401, the emission spectrum 402, and the emission spectrum 406. In contrast, it can be seen that the emission spectrum 403, the emission spectrum 404, and the emission spectrum 405, which correspond to color temperatures from 4000 K to 5000 K, each include red light, green light, and blue light in a well-balanced manner. In particular, the emission spectrum 404, which corresponds to a color temperature of 4200 K, includes red light, green light, and blue light in a highly well-balanced manner.

It is assumed that the relative light intensities of the emission spectra 403, 404, and 405 are included in a range shown as the relative light intensity of the emission spectrum 201. It is assumed that the color rendering indices and the special color rendering indices of light that is specified by the emission spectra 403, 404, and 405 are included in a range shown as the color rendering index and the special color rendering index of light specified by the emission spectrum 201.

The light emitting device 1 according to the present embodiment may emit light having a color temperature in the range of 4000 K to 5000 K. Thus, it is possible to realize the light emitting device 1 that emits light including red light, green light, and blue light in a well-balanced manner.

### <Configuration of Illumination Apparatus>

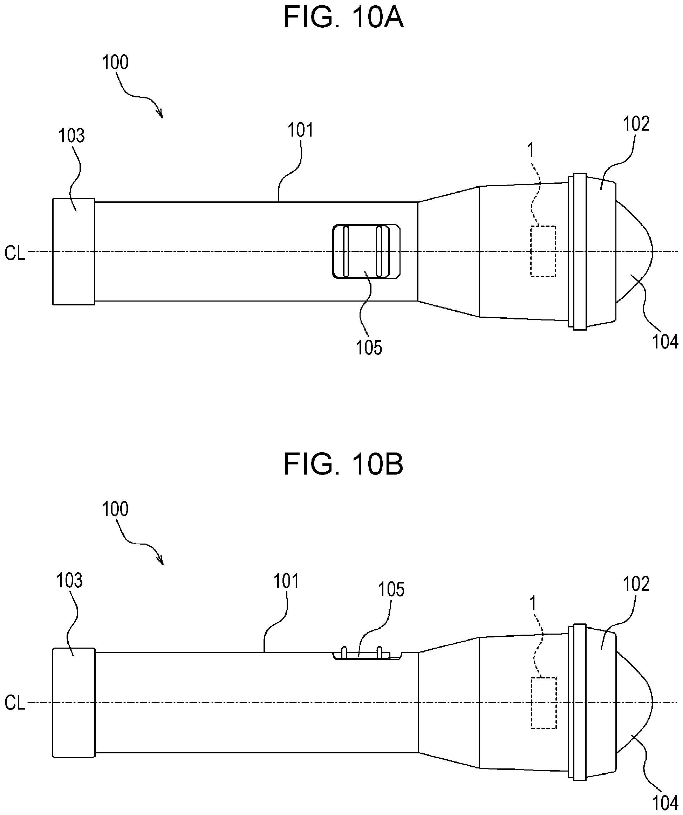

As illustrated in Figs. 10A and 10B, the illumination apparatus 100 according to an embodiment includes the light emitting device 1, a body 101, a flange 102, a power source cover 103, and a lens 104. The number of light emitting devices 1 included in the illumination apparatus 100 is not particularly limited.

The body 101 may have, for example, a cylindrical shape. The length of the body 101 in the longitudinal direction may be, for example, greater than or equal to 10 cm and less than or equal to 20 cm. The length of the body 101 in the transversal direction may be, for example, greater than or equal to 5 cm and less than or equal to 10 cm. The body 101 may be made of, for example, a metal such as aluminum, copper, or stainless steel; or a resin such as a plastic. The body 101 includes a power switch 105 for controlling power on (ON) and power off (OFF) of the illumination apparatus 100. The body 101 may include, for example, a storage-medium insertion slot for inserting a storage medium that can store predetermined information such as an inspection result. The shape of the body 101 is not particularly limited, and may be, for example, a spherical shape, a rectangular-parallelepiped shape, a conical shape, or the like.

The flange 102 is disposed at one end of the body 101 and is used to attach the light emitting device 1 to a predetermined position. The power source cover 103 is disposed at the other end of the body 101 and is used to accommodate a power source, such as a battery, in the body 101. The lens 104 controls the propagation direction of light emitted by the light emitting device 1. The lens 104 condenses light emitted by the light emitting device 1 so that the illumination apparatus 100 can reliably irradiate the irradiation region 502 (see Fig. 1) with light. The irradiation region is a region of a surface that is perpendicular to the central axis CL of the lens 104 and may be, for example, a circular region having a diameter that is less than or equal to 10 cm when the distance between the lens 104 and the surface that is perpendicular to the central axis CL of the lens 104 is 30 cm. When the irradiation region is limited, the intensity of red light that enters an eye of the user 500 who inspects meat is limited. If the intensity of red light that enters the eye is excessively high, the user 500 may receive a strong stimulus and may become unable to perform inspection accurately. When the intensity of red light is limited, the stimulus that the user 500 receives is reduced. As a result, it is possible to increase inspection accuracy.

The type of the illumination apparatus 100 is not particularly limited. The illumination apparatus 100 is not limited to a handy light illustrated in Figs. 10A and 10B, and may a downlight, a ceiling light, a pendant light, a bracket light, or the like, which is set on a ceiling, a wall, a pillar, or the like.

### <Example of Use of Illumination Apparatus>

Next, referring to Fig. 1, an example of a case where the illumination apparatus 100 according to the present embodiment is used to inspect meat will be described.

Light with which the irradiation region 502 is irradiated may be, for example, as illustrated in Fig. 7, light specified by an emission spectrum having a first peak wavelength in a wavelength range of 600 nm to 660 nm, a second peak wavelength in a wavelength range of 510 nm to 550 nm, a third peak wavelength in a wavelength range of 440 nm to 470 nm, and a fourth peak wavelength in a wavelength range of 360 nm to 430 nm.

Light with which the irradiation region 502 is irradiated may be, for example, as illustrated in Fig. 7, when the light intensity at the first peak wavelength is assumed to be 1, light that is specified by an emission spectrum having a relative light intensity that is greater than or equal to 0.75 and less than or equal to 0.98 at the second peak wavelength, a relative light intensity that is greater than or equal to 0.55 and less than or equal to 0.95 at the third peak wavelength, and a relative light intensity that is greater than or equal to 0.50 and less than or equal to 0.85 at the fourth peak wavelength.

Light with which the irradiation region 502 is irradiated may be, for example, as illustrated in Figs. 7 and 9, light having a color temperature of 4200 K.

Light with which the irradiation region 502 is irradiated may be, for example, as illustrated in Fig. 8, light having a special color rendering index R9 and a special color rendering index R12 that are greater than or equal to 90.

The user 500 inspects the meat 501 by irradiating the irradiation region 502 with the aforementioned light by using the illumination apparatus 100. Thus, the user 500 can perform predetermined inspection that is necessary to grade the meat 501 while clearly observing a red portion and a white portion of the meat 501. The illumination apparatus 100 emits light that is specified by an emission spectrum having a first peak wavelength in a wavelength range of 600 nm to 660 nm, a second peak wavelength in a wavelength range of 510 nm to 550 nm, a third peak wavelength in a wavelength range of 440 nm to 470 nm, and a fourth peak wavelength in a wavelength range of 360 nm to 430 nm. Thus, compared with an emission spectrum that is biased toward a long wavelength and a short wavelength, it is possible to reduce the difference in brightness from a long wavelength to a short wavelength, and therefore, it is possible to make it easier to observe a red portion and a white portion. That is, when the intensity of red light or blue light is high, although it is easy to identify each of white and red as a single color, nonuniformity occurs. Therefore, by balancing among red, green, and blue, the color rendering performance can be made natural, and it becomes easy to identify a color.

### <Inspection Results>

Next, inspection results that were obtained when the user 500 actually inspected the meat 501 will be described. The inspection was performed by using the illumination apparatus 100 equipped with the light emitting device 1 according to the present embodiment and an illumination apparatus equipped with the light emitting device according to the comparative example described above. It is assumed that the light emitting device 1 according to the present embodiment emitted light having a color temperature from 2800 K to 6500 K in the inspection. It is assumed that the light emitting device according to the comparative example emitted light specified by the emission spectrum 202.

Table 1 shows the list of inspection results obtained when illumination was performed by using the illumination apparatus 100 according to the present embodiment.

**[Table 1]**

| Color Temperature | Inspection Result |
|---|---|
| 2800 K | x |
| 3000 K | x |
| 4000 K | ○ |
| 4200 K | ○○ |
| 5000 K | ○ |
| 6500 K | x |

When the user 500 inspected the meat 501 illuminated with light having a color temperature of 4200 K, the user 500 evaluated the inspection result as "○○" (double-circle mark). The "○○" (double-circle mark) representing an inspection result means that light corresponding to the mark is highly suitable for inspection of the meat 501. That is, it can be said that the light having a color temperature of 4200 K is highly suitable for inspection of the meat 501. Moreover, it can be said that the light corresponding to "○○" (double-circle mark) is further suitable for inspection of the meat 501 than light corresponding to "○" (single-circle mark) described below. That is, it has been proved that the inspection accuracy when the meat 501 is illuminated by light having a color temperature of 4200 K is very high.

When the user 500 inspected the meat 501 illuminated with light having color temperatures of 4000 K and 5000 K, the user 500 evaluated the inspection results as "○" (single-circle mark). The "○" (single-circle mark) representing an inspection result means that light corresponding to the mark is suitable for inspection of the meat 501. That is, it can be said that the light having color temperatures of 4000 K and 5000 K is suitable for inspection of the meat 501. That is, it has been proved that the inspection accuracy when the meat 501 is illuminated by light having color temperatures of 4000 K and 5000 K is high.

When the user 500 inspected the meat 501 illuminated with light having color temperatures of 2800 K, 3000 K, and 6500 K, the user 500 evaluated the inspection results as "x" (X mark). The "x" (X mark) representing an inspection result means that light corresponding to the mark is not suitable for inspection of the meat 501. That is, it can be said that the light having color temperatures of 2800 K, 3000 K, and 6500 K is not suitable for inspection of the meat 501. That is, it has been proved that the inspection accuracy when the meat 501 is illuminated by light having color temperatures of 2800 K, 3000 K, and 6500 K is low compared with 4000 K, 4200 K, and 5000 K.

When the user 500 inspected the meat 501 illuminated with light that was emitted by the light emitting device according to the comparative example and that was specified by the emission spectrum 202, the user 500 evaluated that the accuracy of the inspection result was low compared with a case where the color temperature was in the range of 4000 to 5000 K, which was about the same as that of the embodiment of the present invention. That is, it can be said that the light specified by the emission spectrum 202 is not suitable for inspection of the meat 501. That is, it has been proved that the inspection accuracy when the meat 501 is illuminated with light specified by the emission spectrum 202 is low.

From the inspection results, it has been proved that the accuracy in inspection of the meat 501 is high when the user 500 inspects the meat 501 illuminated with light having a color temperature in the range of 4000 K to 5000 K. That is, it has been proved that the illumination apparatus 100 that is equipped with the light emitting device 1 that emits light having a color temperature in the range of 4000 K to 5000 K increases the accuracy in inspection of the meat 501.

From the inspection results, it has been proved that the accuracy in inspection of the meat 501 is the highest when the user 500 inspects the meat 501 illuminated with light having a color temperature of 4200 K. That is, it has been proved that the illumination apparatus 100 in which the light emitting device 1 that emits light having a color temperature of 4200 K further increases the accuracy in inspection of the meat 501.

From the inspection results, it has been proved that the accuracy in inspection of the meat 501 is low when the user 500 inspects the meat 501 illuminated with light having a color temperature lower than 4000 K, light having a color temperature higher than 5000 K, or light specified by the emission spectrum 202. That is, it has been proved that an illumination apparatus that is equipped with a light emitting device that emits light having a color temperature lower than 4000 K, light having a color temperature higher than 5000 K, or light specified by the emission spectrum 202 has low inspection accuracy.

That is, it can be seen that the illumination apparatus 100, which is equipped with the light emitting device 1 according to an embodiment of the present invention that emits light having a color temperature in the range of 4000 K to 5000 K, emits light in which red light is not too intense and blue light is not too intense and that is suitable for inspection of meat. It can be seen that the illumination apparatus 100 that is equipped with the light emitting device 1 that emits light having a color temperature of 4200 K emits light that is the most suitable for inspection of meat. On the other hand, it can be seen that an illumination apparatus that is equipped with a light emitting device that emits light having a color temperature of 2800 K or 3000 K and light specified by the emission spectrum 202 emits light in which red light is too intense and that is not suitable for inspection of meat. Moreover, it can be seen that an illumination apparatus that is equipped with a light emitting device that emits light having a color temperature of 6500 K emits light in which blue light is too intense and that is not suitable for inspection of meat.

Accordingly, it can be seen that, when the color temperature is in the range of 4000 K to 5000 K, the light emitting device emits light that is suitable for inspection of meat. In particular, it can be seen that, when the color temperature is 4200 K, the light emitting device emits light that is the most suitable for inspection of meat. Moreover, it can be said that light having a color temperature in the range of 4000 K to 5000 K has high color rendering performance and is close to sunlight.

The illumination apparatus 100 according to the present embodiment can increase the accuracy in inspection of meat, because the illumination apparatus 100 is equipped with the light emitting device 1 that emits light close to sunlight. The illumination apparatus 100 according to the present embodiment can increase the accuracy in inspection of meat, because the illumination apparatus 100 is equipped with the light emitting device 1 having high color rendering performance. The illumination apparatus 100 according to the present embodiment can increase the accuracy in inspection of meat, because the illumination apparatus 100 is equipped with the light emitting device 1 that emits light having a color temperature suitable for inspection of meat.

The illumination apparatus 100 according to the present embodiment can improve the accuracy in inspection of meat, because the illumination apparatus 100 is equipped with the light emitting device 1 that emits light having a color temperature in the range of 4000 K to 5000 K.

The illumination apparatus 100 according to the present embodiment can greatly improve the accuracy in inspection of meat, because the illumination apparatus 100 is equipped with the light emitting device 1 that emits light having a color temperature of 4200 K.

The illumination apparatus 100 according to the present embodiment is equipped with the light emitting device 1 including the plurality of light emitting elements 3 that emit light having a peak wavelength in a wavelength range of 360 nm to 430 nm and the wavelength conversion member 6 including the first phosphor 61, the second phosphor 62, and the third phosphor 63. That is, the light emitting device 1 includes the light emitting elements 3 having a peak wavelength in a purple light range and the wavelength conversion member 6 in which the first phosphor 61, the second phosphor 62, and the third phosphor 63 are contained with an optimum balance. Therefore, the illumination apparatus 100 can greatly improve the accuracy in inspection of meat.

### <Modifications>

In the present embodiment, it has been described that the wavelength conversion member 6 includes, as phosphors, at least the first phosphor 61, the second phosphor 62, and the third phosphor 63. The wavelength conversion member 6 may include a phosphor of another type. The wavelength conversion member 6 may include four types of phosphors or may include five or more types of phosphors.

Advantageous effects that can be realized by the light emitting device 1 can be realized also by the illumination apparatus 100 including the light emitting device 1.

### (Embodiment regarding Fresh Fish Inspection)

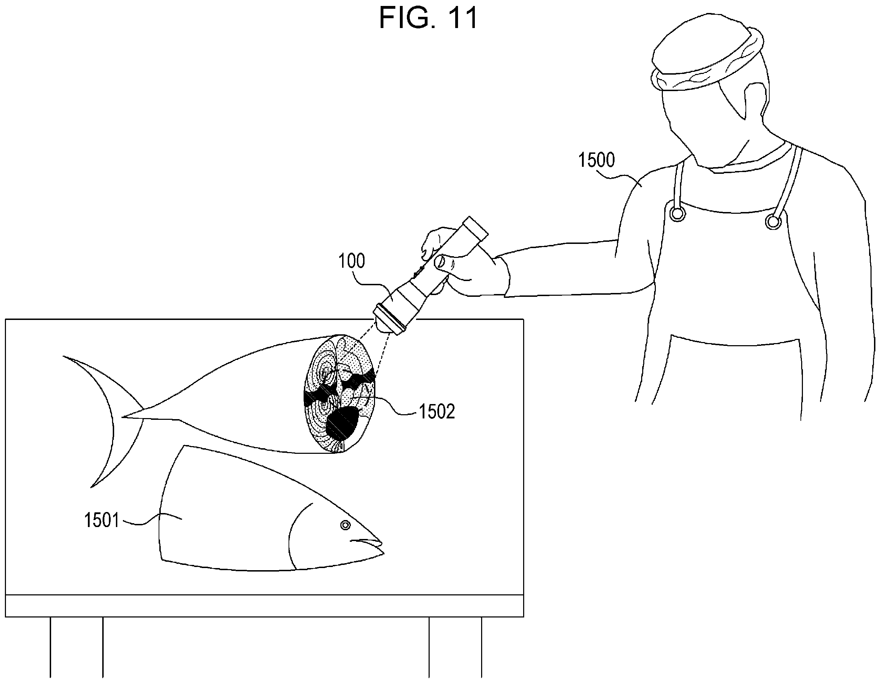

As illustrated in Fig. 11, the illumination apparatus 100 is used by a user 1500 to inspect fresh fish 1501. The user 1500 is, for example, a wholesaler who trades the fresh fish 1501. The fresh fish 1501 means a raw fish that is expected to be fresh and may include, tuna, skipjack, or the like.

Freshness may be the most important factor that determines the quality of the fresh fish 1501. When, for example, a tuna is carried into a market, the user 1500 inspects the tuna by irradiating an irradiation region 1502 with light by using the illumination apparatus 100. The inspection may include, for example, inspection of an individual difference such as whether the fresh fish 1501 has a large amount of red meat or a large amount of fat. The inspection may include a food hygiene inspection for checking whether or not the fresh fish 1501 has a jelly-like portion, a disease, an internal hemorrhage, a damaged portion, or the like. The user 1500 inspects a red portion called "red meat" and a white portion called "marbling". The user 1500 may predominantly inspect "red meat". By irradiating the fresh fish 1501 with light of the illumination apparatus 100, the user 1500 can perform inspection of the fresh fish 1501, including inspection of the balance between "red meat" and "marbling" or inspection of red meat, with high accuracy.

Hereafter, an embodiment in which the illumination apparatus 100 is used for inspection of the fresh fish 1501 will be described. At least part of the light emitting device 1 according to the present embodiment is the same as or similar to the light emitting device 1 according to the embodiment in which the illumination apparatus 100 is used for inspection of the meat 501. The following description will be made by focusing on the difference between the configuration of the illumination apparatus 100 according to the present embodiment used for inspection of the fresh fish 1501 and the configuration of the illumination apparatus 100 used for inspection of the meat 501. Configurations of the illumination apparatus 100 according to the present embodiment whose descriptions are omitted may be the same as or similar to the configuration of the illumination apparatus 100 used for inspection of the meat 501. To be specific, description related to the configuration of the light emitting device 1 is omitted. On the other hand, hereafter, the emission spectrum of the light emitting device 1 will be described.

### <Emission Spectrum of Light Emitting Device>

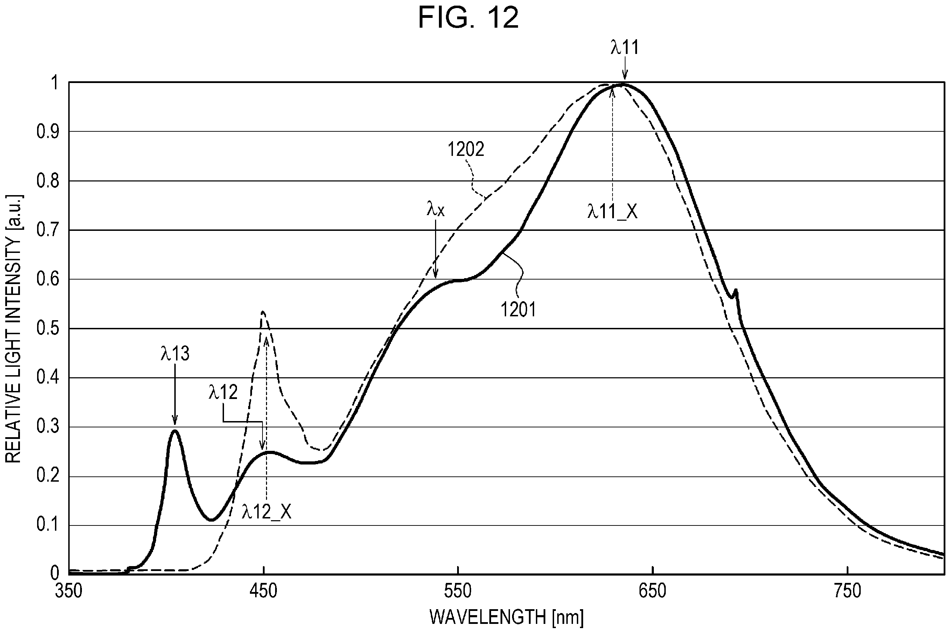

Referring to Fig. 12, an emission spectrum 1201 of the light emitting device 1 according to the present embodiment and an emission spectrum 1202 of a light emitting device according to a comparative example will be described. The emission spectra are measured, for example, by spectroscopy using a spectrophotometry device or the like. In the graph of Fig. 12, the horizontal axis and the vertical axis respectively represent the wavelength and the relative light intensity of light emitted by the light emitting device.

The light emitting device 1 emits light in which light emitted by the first phosphor 61, light emitted by the second phosphor 62, light emitted by the third phosphor 63, and light emitted by the plurality of light emitting elements 3 are synthesized in a wavelength range of 360 nm to 780 nm.

As illustrated in Fig. 12, the emission spectrum 1201 has a first peak wavelength λ1 in a wavelength range of 600 nm to 660 nm. The first peak wavelength λ11 corresponds to the wavelength of light emitted by the first phosphor 61. The emission spectrum 1201 has another peak wavelength λx in a wavelength range of 510 nm to 550 nm. The other peak wavelength λx corresponds to the wavelength of light emitted by the second phosphor 62. The emission spectrum 1201 has a second peak wavelength λ2 in a wavelength range of 440 nm to 470 nm. The second peak wavelength λ12 corresponds to the wavelength of light emitted by the third phosphor 63. The emission spectrum 1201 has a third peak wavelength λ13 in a wavelength range of 360 nm to 430 nm. That is, the emission spectrum 1201 has four peak wavelengths.

In the emission spectrum 1201, when the light intensity at first peak wavelength λ11 is assumed to be 1, the relative light intensity at the second peak wavelength λ12 is greater than or equal to 0.15 and less than or equal to 0.35. In the emission spectrum 1201, the relative light intensity at the third peak wavelength λ13 is greater than or equal to 0.2 and less than or equal to 0.4.

On the other hand, the light emitting device according to the comparative example emits light in which light emitted by a predetermined phosphor and light emitted by a plurality of predetermined light emitting devices are synthesized in a wavelength range of 360 nm to 780 nm. The predetermined phosphor is, for example, a first phosphor having a first peak wavelength λ11_X in a wavelength range of 600 nm to 660 nm. The first phosphor converts light that has entered a wavelength conversion member into light having the first peak wavelength λ11_X in the wavelength range of 600 nm to 660 nm, and emits the converted light. The predetermined light emitting device is, for example, a light emitting device that emits light having a second peak wavelength λ12_X in a wavelength range of 440 nm to 470 nm (so-called blue excitation light).

As illustrated in Fig. 12, the emission spectrum 1202 of the comparative example has the first peak wavelength λ11_X in the wavelength range of 600 nm to 660 nm and the second peak wavelength λ12_X in the wavelength range of 440 nm to 470 nm. That is, the emission spectrum 1202 has two peak wavelengths.

The light emitting device 1 according to the present embodiment emits light that is specified by the emission spectrum 1201 having the first peak wavelength λ11 in the wavelength range of 600 nm to 660 nm. The light emitting device 1 emits light that is specified by the emission spectrum 1201 having the other peak wavelength λx in the wavelength range of 510 nm to 550 nm. The light emitting device 1 emits light that is specified by the emission spectrum 1201 having the second peak wavelength λ12 in the wavelength range of 440 nm to 470 nm. The light emitting device 1 emits light that is specified by the emission spectrum 1201 having the third peak wavelength λ13 in the wavelength range of 360 nm to 430 nm. When the light intensity at the first peak wavelength λ11 is assumed to be 1, the relative light intensity at the second peak wavelength λ12 is greater than or equal to 0.15 and less than or equal to 0.35. When the light intensity at the first peak wavelength λ11 is assumed to be 1, the relative light intensity at the third peak wavelength λ13 is greater than or equal to 0.2 and less than or equal to 0.5. Light that is specified by the emission spectrum 1201 includes red light, green light, and blue light each with a proportion close to that of the spectrum of sunlight. Thus, it is possible to realize the light emitting device 1 that emits light in which light of all colors from blue to red are uniformly dispersed and that is close to sunlight, in particular, sunlight at about sunrise/sunset.

### <Color Rendering Performance of Light Emitting Device>

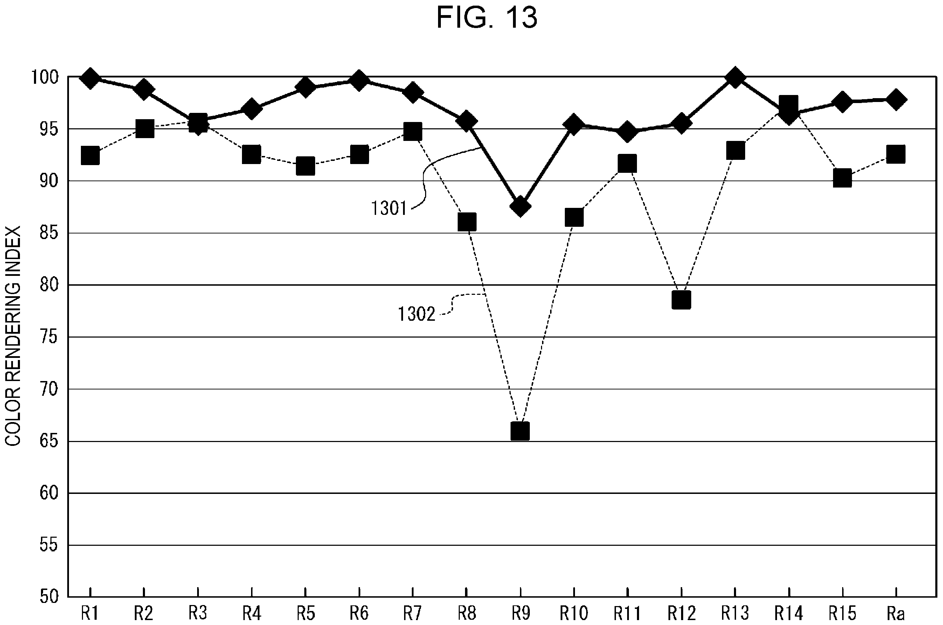

Next, referring to Fig. 13, the color rendering performance of the light emitting device 1 according to the present embodiment and the color rendering performance of the light emitting device according to the comparative example, which is shown by the emission spectrum 1202, will be described. In the graph of Fig. 13, the horizontal axis and the vertical axis respectively represent a test color and a color rendering index. A graph 1301 is a graph in which the values of the color rendering index of the light emitting device 1 for the test colors are plotted and connected by a solid line. A graph 1302 is a graph in which the values of the color rendering index of the light emitting device according to the comparative example for the test colors are plotted and connected by a broken line.

The term "color rendering performance" refers to an indicator for evaluating the quality of a light source as to how a color looks with respect to natural light, and is numerically represented by a color rendering index. The color rendering index can be represented by an average color rendering index Ra, a special color rendering index R9, a special color rendering index R10, a special color rendering index R11, a special color rendering index R12, a special color rendering index R13, a special color rendering index R14, a special color rendering index R15, and the like. Examples of a light source having an average color rendering index Ra = 100 include the Sun and an incandescent lamp.

As illustrated in Fig. 13, in the graph 1301, the average color rendering index Ra is greater than or equal to 95. The special color rendering index R9 is greater than or equal to 85. The special color rendering index R10 is about 95. The special color rendering index R11 is about 95. The special color rendering index R12 is about 95. The special color rendering index R13 is about 100. The special color rendering index R14 is greater than or equal to 95. The special color rendering index R15 is greater than or equal to 95.

As illustrated in Fig. 13, in the graph 1302, the average color rendering index Ra is greater than or equal to 90. The special color rendering index R9 is about 65. The special color rendering index R10 is about 85. The special color rendering index R11 is greater than or equal to 90. The special color rendering index R12 is about 78. The special color rendering index R13 is greater than or equal to 90. The special color rendering index R14 is greater than or equal to 95. The special color rendering index R15 is about 90.

It can be seen from Fig. 13 that the color rendering indices of the light emitting device 1 for the test colors are all greater than or equal to 85 and have very small variation. In contrast, it can be seen that the color rendering indices of the light emitting device according to the comparative example for the test colors have values that are greater than or equal to 90 and values that are less than equal to 70 and have very large variation. Accordingly, it can be seen that the color rendering performance of the light emitting device 1 is higher than that of the light emitting device according to the comparative example.

The light emitting device 1 according to the present embodiment emits light having a special color rendering index R9 that is greater than or equal to 85, and emits light having a special color rendering index R12 that is greater than or equal to 90. Thus, it is possible to realize the light emitting device 1 having an average color rendering index Ra and special color rendering indices R9, R10, R11, R12, R13, R14, and R15 that are all greater than or equal to 85 and having high color rendering performance.

### <Color Temperature of Light Emitting Device>

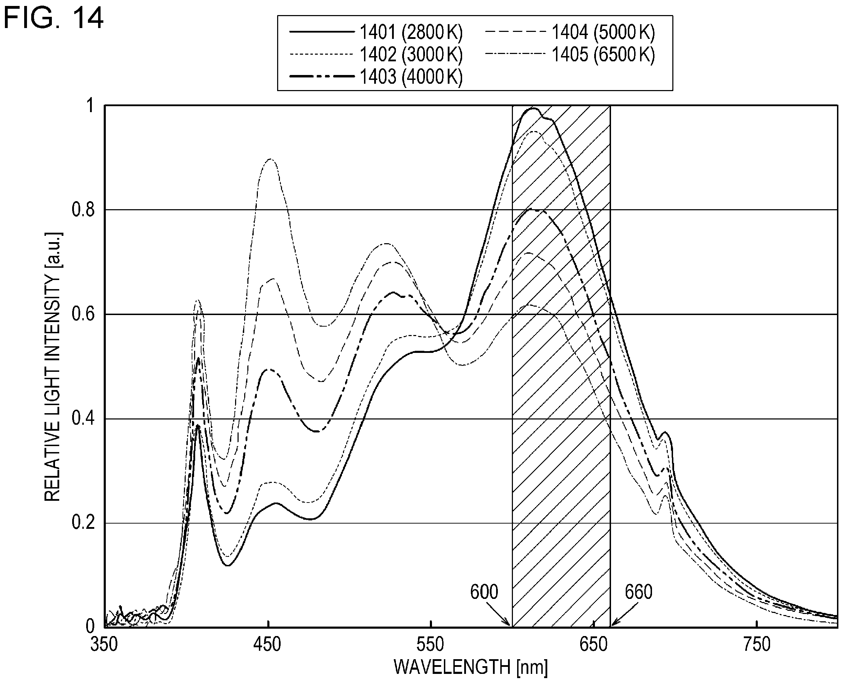

Next, referring to Fig. 14, the emission spectrum of the light emitting device when the color temperature differs will be described. The emission spectrum is measured, for example, by spectroscopy using a spectrophotometry device or the like. In the graph of Fig. 14, the horizontal axis and the vertical axis respectively represent the wavelength and the relative light intensity of light emitted by the light emitting device.

A color temperature is a value representing the color of light emitted by a light source and is represented by a unit called kelvin (K). A low color temperature means that the light source emits reddish light. A high color temperature means that the light source emits bluish light. For example, the color temperature of light emitted by an incandescent lamp is about 2800 K. For example, the color temperature of neutral light is about 4200 K.

Light that is specified by an emission spectrum 1401 has a color temperature of 2800 K. Light that is specified by an emission spectrum 1402 has a color temperature of 3000 K. Light that is specified by an emission spectrum 1403 has a color temperature of 4000 K. Light that is specified by an emission spectrum 1404 has a color temperature of 5000 K. Light that is specified by an emission spectrum 1405 has a color temperature of 6500 K. The relative light intensity of each of the emission spectra 1402, 1403, 1404, and 1405 is represented as the ratio of light intensity to light intensity at a peak wavelength when the light intensity of the emission spectrum 1401 at the maximum peak wavelength is assumed to be 1.

It can be seen from Fig. 14 that, in a wavelength range of 360 nm to 780 nm, the relative light intensity of the emission spectrum 1401 in a wavelength range of 600 nm to 660 nm is very high compared with the relative light intensity in a wavelength range of 440 nm to 470 nm and the relative light intensity in a wavelength range of 510 nm to 550 nm. That is, it can be seen that red light is dominant in light having a color temperature of 2800 K.

It can be seen from Fig. 14 that, in a wavelength range of 360 nm to 780 nm, the relative light intensity of the emission spectrum 1402 in a wavelength range of 600 nm to 660 nm is slightly high compared with the relative light intensity in a wavelength range of 440 nm to 470 nm and the relative light intensity in a wavelength range of 510 nm to 550 nm. That is, it can be seen that red light is dominant in light having a color temperature of 3000 K.

It can be seen from Fig. 14 that, in a wavelength range of 360 nm to 780 nm, the relative light intensity of the emission spectrum 1403 in a wavelength range of 600 nm to 660 nm is slightly high compared with the relative light intensity in a wavelength range of 440 nm to 470 nm and the relative light intensity in a wavelength range of 510 nm to 550 nm. That is, it can be seen that red light is dominant in light having a color temperature of 4000 K.

It can be seen from Fig. 14 that, in a wavelength range of 360 nm to 780 nm, the relative light intensity of the emission spectrum 1404 in a wavelength range of 600 nm to 660 nm does not differ so much from the relative light intensity in a wavelength range of 440 nm to 470 nm and the relative light intensity in a wavelength range of 510 nm to 550 nm. That is, it can be seen that light having a color temperature of 5000 K includes a larger amount of each of green light and blue light compared with the spectra 1401, 1402, and 1403.

It can be seen from Fig. 14 that, in a wavelength range of 360 nm to 780 nm, the relative light intensity of the emission spectrum 1405 in a wavelength range of 600 nm to 660 nm is slightly low compared with the relative light intensity in a wavelength range of 440 nm to 470 nm and the relative light intensity in a wavelength range of 510 nm to 550 nm. That is, it can be seen that blue light is dominant in light having a color temperature of 6500 K.

Accordingly, it can be seen from Fig. 14 that red light is more intense than green light and blue light in the emission spectrum 1401 corresponding to a color temperature of 2800 K, the emission spectrum 1402 corresponding to a color temperature of 3000 K, and the emission spectrum 1403 corresponding to a color temperature of 4000 K. On the other hand, it can be seen that green light and blue light are more intense than red light in the emission spectrum 1404 corresponding to a color temperature of 5000 K, in contrast to the spectra 1401, 1402, and 1403. Moreover, it can be seen that blue light is more intense than green light and red light in the emission spectrum 1405 corresponding to a color temperature of 6500 K.

It is assumed that the relative light intensities of the emission spectra 1401, 1402, and 1403 are included in a range shown as the relative light intensity of the emission spectrum 1201. It is assumed that the color rendering indices and the special color rendering indices of light that is specified by the emission spectra 1401, 1402, and 1403 are included in a range shown as the color rendering index and the special color rendering index of light specified by the emission spectrum 1201.

The light emitting device 1 according to the present embodiment emits light having a color temperature in the range of 2800 K to 4000 K. Thus, it is possible to realize the light emitting device 1 that emits red light more intensely than green light and blue light. Moreover, the user 1500 can inspect, in particular, a red portion called "red meat" with high accuracy, because the illumination apparatus 100 described below is equipped with the light emitting device 1 according to the present embodiment.

### <Configuration of Illumination Apparatus>

As illustrated in Figs. 10A and 10B, the illumination apparatus 100 according to an embodiment includes the light emitting device 1, the body 101, the flange 102, and the power source cover 103. The number of light emitting devices 1 included in the illumination apparatus 100 is not particularly limited. Detailed description of each constituent part, which has been described with reference to Figs. 10A and 10B, is omitted here.

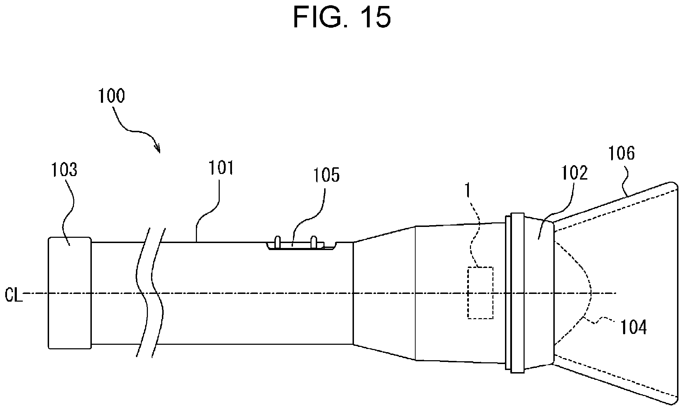

As illustrated in Fig. 15, the illumination apparatus 100 may further include a reflector 106. The reflector 106 is made of, for example, glass, resin, or the like. A reflection layer is formed on an inner peripheral surface the reflector 106 from a reflective material such as aluminum, and the inner peripheral surface functions as a reflection surface. The shape of the reflector 106 is, for example, a cup-like shape. The reflector 106 has an opening on both of a side on which the light emitting device 1 is disposed and a side opposite to the side on which the light emitting device 1 is disposed. The reflector 106 is disposed in such a way that the central axis thereof overlaps the central axis CL of the lens 104. The shape of the reflector 106 may be designed in any appropriate manner in accordance with the area of the irradiation region 1502 and the like.

For example, in a case where the user 1500 wants to illuminate a narrow region of the fresh fish 1501 by using the illumination apparatus 100, the illumination apparatus 100 may include the lens 104 (see Figs. 10A and 10B). In this case, the lens 104 is, for example, a condensing lens.

For example, in a case where the user 1500 wants to illuminate a wide region of the fresh fish 1501 by using the illumination apparatus 100, the illumination apparatus 100 may include the lens 104 and the reflector 106 (see Fig. 15). In this case, the lens 104 is, for example, a diffusing lens.

The type of the illumination apparatus 100 is not particularly limited. The illumination apparatus 100 is not limited to a handy light illustrated in Figs. 10A, 10B, and 15, and may a downlight, a ceiling light, a pendant light, a bracket light, or the like, which is set on a ceiling, a wall, a pillar, or the like.

### <Example of Use of Illumination Apparatus>

Next, referring to Fig. 11, an example of a case where the illumination apparatus 100 according to the present embodiment is used to inspect the fresh fish 1501 will be described.

Light with which the irradiation region 1502 is irradiated may be, for example, as illustrated in Fig. 12, light specified by an emission spectrum having a first peak wavelength in a wavelength range of 600 nm to 660 nm, a second peak wavelength in a wavelength range of 440 nm to 470 nm, and a third peak wavelength in a wavelength range of 360 nm to 430 nm.

In light with which the irradiation region 1502 is irradiated, for example, as illustrated in Fig. 12, when the light intensity at the first peak wavelength is assumed to be 1, the relative light intensity at the second peak wavelength is greater than or equal to 0.15 and less than or equal to 0.35. When the light intensity at the first peak wavelength is assumed to be 1, the relative light intensity at the third peak wavelength may be greater than or equal to 0.2 and less than or equal to 0.5.

Light with which the irradiation region 1502 is irradiated may be, for example, as illustrated in Figs. 12 and 14, light having a color temperature of 3000 K.

Light with which the irradiation region 1502 is irradiated may be, for example, as illustrated in Fig. 13, light having a special color rendering index R9 that is greater than or equal to 85 and having a special color rendering index R12 that is greater than or equal to 95.

The user 1500 inspects the fresh fish 1501 by irradiating the irradiation region 1502 with the aforementioned light by using the illumination apparatus 100. Thus, the user 1500 can inspect, while clearly observing a red portion of the fresh fish 1501 called "red meat" and a white portion of the fresh fish 1501 called "marbling", in particular, the "red meat" portion of the fresh fish 1501 with high accuracy.

The illumination apparatus 100 according to the present embodiment is equipped with the light emitting device 1 that emits light that is specified by an emission spectrum having a first peak wavelength in a wavelength range of 600 nm to 660 nm, a second peak wavelength in a wavelength range of 440 nm to 470 nm, and a third peak wavelength in a wavelength range of 360 nm to 430 nm. In the emission spectrum, the relative light intensity at the second peak wavelength is greater than or equal to 0.15 and less than or equal to 0.25, and the relative light intensity at the third peak wavelength is greater than or equal to 0.2 and less than or equal to 0.5. Thus, it is possible to realize the illumination apparatus 100 that has increased accuracy in inspection of fresh fish.

### <Inspection Results>

Next, inspection results that were obtained when the user 1500 actually inspected the fresh fish 1501 will be described. The inspection was performed by using the illumination apparatus 100 equipped with the light emitting device 1 according to the present embodiment and an illumination apparatus equipped with the light emitting device according to the comparative example described above. It is assumed that the light emitting device 1 according to the present embodiment emitted light having a color temperature from 2800 K to 6500 K in the inspection. It is assumed that the light emitting device according to the comparative example emitted light specified by the emission spectrum 1202 in the inspection.

Table 2 shows the list of inspection results obtained when illumination was performed by using the illumination apparatus 100 according to the present embodiment. The present inspection result is the determination result obtained by a plurality of users 1500.

**[Table 2]**

| Color Temperature | Inspection Result |
|---|---|
| 2800 K | ○ |
| 3000 K | ○○ |
| 4000 K | ○ |
| 5000 K | x |
| 6500 K | x |

When the user 1500 inspected the fresh fish 1501 illuminated with light having a color temperature of 3000 K, the user 1500 evaluated the inspection result as "○○" (double-circle mark). The "○○" (double-circle mark) representing an inspection result means that light corresponding to the mark is highly suitable for inspection of the fresh fish 1501. That is, it can be said that the light having a color temperature of 3000 K is highly suitable for inspection of the fresh fish 1501. Moreover, it can be said that the light corresponding to "○○" (double-circle mark) is further suitable for inspection of the fresh fish 1501 than light corresponding to "○" (single-circle mark) described below. That is, it has been proved that the inspection accuracy when the fresh fish 1501 is illuminated by light having a color temperature of 3000 K is very high.

When the user 1500 inspected the fresh fish 1501 illuminated with light having color temperatures of 2800 K and 4000 K, the user 1500 evaluated the inspection results as "○" (single-circle mark). The "○" (single-circle mark) representing an inspection result means that light corresponding to the mark is suitable for inspection of the fresh fish 1501. That is, it can be said that the light having color temperatures of 2800 K and 4000 K is suitable for inspection of the fresh fish 1501. That is, it has been proved that the inspection accuracy when the fresh fish 1501 is illuminated by light having color temperature of 2800 K and 4000 K is high.

When the user 1500 inspected the fresh fish 1501 illuminated with light having color temperatures of 5000 K and 6500 K, the user 1500 evaluated the inspection result as "x" (X mark). The "x" (X mark) representing an inspection result means that light corresponding to the mark is not suitable for inspection of the fresh fish 1501. That is, it can be said that the light having color temperatures of 5000 K and 6500 K is not suitable for inspection of the fresh fish 1501. That is, it has been proved that the inspection accuracy when the fresh fish 1501 is illuminated by light having color temperatures of 5000 K and 6500 K is low compared with 2800 K, 3000 K, and 4200 K.

When the user 1500 inspected the fresh fish 1501 illuminated with light that was emitted by the light emitting device according to the comparative example and that was specified by the emission spectrum 1202, the user 1500 evaluated that the accuracy of the inspection result was low compared with a case where the color temperature was in the range of 2800 to 4000 K, which was about the same as that of the embodiment of the present invention. That is, it can be said that the light specified by the emission spectrum 1202 is not suitable for inspection of the fresh fish 1501. That is, it has been proved that the inspection accuracy when the fresh fish 1501 is illuminated with light specified by the emission spectrum 1202 is very low.

From the inspection results, it has been proved that the accuracy in inspection of the fresh fish 1501 is high when the user 1500 inspects the fresh fish 1501 illuminated with light having a color temperature in the range of 2800 K to 4000 K. That is, it has been proved that the illumination apparatus 100 that is equipped with the light emitting device 1 that emits light having a color temperature in the range of 2800 K to 4000 K can increase the accuracy in inspection of the fresh fish 1501.

From the inspection results, it has been proved that the accuracy in inspection of the fresh fish 1501 is the highest when the user 1500 inspects the fresh fish 1501 illuminated with light having a color temperature of 3000 K. That is, it has been proved that the illumination apparatus 100 in which the light emitting device 1 that emits light having a color temperature of 3000 K further increases the accuracy in inspection of the fresh fish 1501.

From the inspection results, it has been proved that the accuracy in inspection of the fresh fish 1501 is low when the user 1500 inspects the fresh fish 1501 illuminated with light having a color temperature higher than 4000 K or light specified by the emission spectrum 1202. That is, it has been proved that an illumination apparatus that is equipped with a light emitting device that emits light having a color temperature higher than 4000 K or light specified by the emission spectrum 1202 has low inspection accuracy.

That is, the illumination apparatus 100, which is equipped with the light emitting device 1 according to an embodiment of the present invention that emits light having a color temperature in the range of 2800 K to 4000 K, emits light in which red light is intense in an appropriate range while blue light is not too intense. Thus, it can be seen that the illumination apparatus 100, which is equipped with the light emitting device 1 that emits light having a color temperature in the range of 2800 K to 4000 K, is the most suitable for inspection of the fresh fish 1501. Moreover, it can be seen that the illumination apparatus 100 that is equipped with the light emitting device 1 that emits light having a color temperature of 3000 K emits light that is the most suitable for inspection of the fresh fish 1501. On the other hand, it can be seen that an illumination apparatus that is equipped with a light emitting device that emits light having a color temperature higher than 4000 K emits light in which blue light is too intense or red light is too weak and that is not suitable for inspection of the fresh fish 1501.

Accordingly, it can be seen that, when the color temperature is in the range of 2800 K to 4000 K as in the present embodiment, the light emitting device 1 emits light that is suitable for inspection of the fresh fish 1501. In particular, it can be seen that, when the color temperature is 3000 K, the light emitting device emits light that is the most suitable for inspection of the fresh fish 1501. Moreover, it can be said that light having a color temperature in the range of 2800 K to 4000 K has high color rendering performance.

The illumination apparatus 100 according to the present embodiment can increase the accuracy in inspection of the fresh fish 1501, because the illumination apparatus 100 is equipped with the light emitting device 1 that emits light close to sunlight. The illumination apparatus 100 according to the present embodiment can increase the accuracy in inspection of the fresh fish 1501, because the illumination apparatus 100 is equipped with the light emitting device 1 having high color rendering performance. The illumination apparatus 100 according to the present embodiment can increase the accuracy in inspection of the fresh fish 1501, because the illumination apparatus 100 is equipped with the light emitting device 1 that emits light having a color temperature suitable for inspection of the fresh fish 1501.

The illumination apparatus 100 according to the present embodiment can improve the accuracy in inspection of the fresh fish 1501, because the illumination apparatus 100 is equipped with the light emitting device 1 that emits light having a color temperature in the range of 2800 K to 4000 K. The illumination apparatus 100 according to the present embodiment can greatly improve the accuracy in inspection of the fresh fish 1501, because the illumination apparatus 100 is equipped with the light emitting device 1 that emits light having a color temperature of 3000 K.

The illumination apparatus 100 according to the present embodiment is equipped with the light emitting device 1 including the plurality of light emitting elements 3 that emit light having a peak wavelength in a wavelength range of 360 nm to 430 nm and the wavelength conversion member 6 including the first phosphor 61, the second phosphor 62, and the third phosphor 63. That is, the light emitting device 1 includes the light emitting elements 3 having a peak wavelength in a purple light range and the wavelength conversion member 6 in which the first phosphor 61, the second phosphor 62, and the third phosphor 63 are contained with an optimum balance. Therefore, the illumination apparatus 100 can greatly improve the accuracy in inspection of the fresh fish 1501.

In the present embodiment, ordinal numbers such as "first" and "second" are identifiers for discriminating between the elements. In the present disclosure, regarding the elements that are discriminated by the ordinal numbers such as "first" and "second", the ordinal numbers may be replaced with each other. For example, the identifiers "first" and "second" of the first phosphor and the second phosphor may be replaced with each other. Replacement of the identifiers is performed simultaneously. Even after the replacement of identifiers, the elements are discriminated. The identifiers may be omitted. Elements from which the identifiers are omitted are discriminated by reference numerals. In the present disclosure, the identifiers "first", "second", and the like should not be used for the interpretation of the order of the elements and as the basis for the presence of an identifier with a smaller number.

As described above, the illumination apparatus 100 may be used, for example, for inspection of fresh fish in addition to inspection of the meat 501. As with meat inspection, it is possible to perform a predetermined inspection with high accuracy, because a red portion and a white portion can be clearly observed. The term "fresh fish" refers to a raw fish in a fresh state and may be, for example, tuna, skipjack, or the like.

The illumination apparatus 100 may be used not only in an indoor space such as in a building or a house but also in an outdoor space.

The figures illustrating configurations according to the present embodiment are schematic. Scales and the like in the figures do not necessarily coincide with real ones.

It should be clear for a person having ordinary skill in the art that the embodiment described above, which has been described as a representative example, can be changed and substituted in many ways within the spirit and scope of the present disclosure. It should not be understood that the configuration according to the present disclosure is not limited by the embodiment described above. The configuration may be modified or changed in various ways within the scope of the claims. Embodiments according to the present disclosure are not limited to the example of the embodiment described above, and numerical values and the like may be changed in various ways. Combinations of the characteristic parts of the present embodiment are not limited to the example in the embodiment described above. Reference Signs List

1 light emitting device (2: element substrate, 3: light emitting element, 4: frame, 5: sealing member, 6: wavelength conversion member, 61: first phosphor, 62: second phosphor, 63: third phosphor)
100 illumination apparatus (101: body, 102: flange, 103: power source cover, 104: lens, 105: power switch, 106: reflector)
301, 302, 1301, 1302 graph
401 to 406, 1401 to 1405 emission spectrum
500, 1500 user
501, 1501 meat, fresh fish
502, 1502 irradiation region

## Claims

1. A light emitting device
that emits light that is specified by an emission spectrum having a first peak wavelength in a wavelength range of 600 nm to 660 nm, a second peak wavelength in a wavelength range of 510 nm to 550 nm, a third peak wavelength in a wavelength range of 440 nm to 470 nm, and a fourth peak wavelength in a wavelength range of 360 nm to 430 nm,
wherein, when a light intensity at the first peak wavelength is assumed to be 1, a relative light intensity at the second peak wavelength is greater than or equal to 0.75 and less than or equal to 0.98, a relative light intensity at the third peak wavelength is greater than or equal to 0.55 and less than or equal to 0.95, and a relative light intensity at the fourth peak wavelength is greater than or equal to 0.50 and less than or equal to 0.85.

2. The light emitting device according to Claim 1, comprising:
a plurality of light emitting elements that emit light having the fourth peak wavelength;
a first phosphor that converts the light emitted by the plurality of light emitting elements into light having the first peak wavelength;
a second phosphor that converts the light emitted by the plurality of light emitting elements into light having the second peak wavelength; and
a third phosphor that converts the light emitted by the plurality of light emitting elements into light having the third peak wavelength.

3. The light emitting device according to Claim 1 or 2, wherein the light that is specified by the emission spectrum has a color temperature in a range of 4000 K to 5000 K.

4. The light emitting device according to any one of Claims 1 to 3, wherein the light emitting device emits light having a special color rendering index R9 that is greater than or equal to 90.

5. The light emitting device according to any one of Claims 1 to 4, wherein the light emitting device emits light having a special color rendering index R12 that is greater than or equal to 90.

6. An illumination apparatus comprising at least one light emitting device according to any one of Claims 1 to 5.

7. The illumination apparatus according to Claim 6, wherein the illumination apparatus is used to inspect meat.

8. A light emitting device
that emits light that is specified by an emission spectrum having a first peak wavelength in a wavelength range of 600 nm to 660 nm, a second peak wavelength in a wavelength range of 440 nm to 470 nm, and a third peak wavelength in a wavelength range of 360 nm to 430 nm,
wherein, when a light intensity at the first peak wavelength is assumed to be 1, a relative light intensity at the second peak wavelength is greater than or equal to 0.15 and less than or equal to 0.35, and a relative light intensity at the third peak wavelength is greater than or equal to 0.2 and less than or equal to 0.5.

9. The light emitting device according to Claim 8, comprising:
a plurality of light emitting elements that emit light having the third peak wavelength;
a first phosphor that converts the light emitted by the plurality of light emitting elements into light having the first peak wavelength; and
a second phosphor that converts the light emitted by the plurality of light emitting elements into light having the second peak wavelength.

10. The light emitting device according to Claim 8 or 9, wherein the light that is specified by the emission spectrum has a color temperature in a range of 2800 K to 4000 K.

11. The light emitting device according to any one of Claims 8 to 10, wherein the light emitting device emits light having a special color rendering index R9 that is greater than or equal to 85.

12. The light emitting device according to any one of Claims 8 to 11, wherein the light emitting device emits light having a special color rendering index R12 that is greater than or equal to 90.

13. An illumination apparatus comprising at least one light emitting device according to any one of Claims 8 to 12.

14. The illumination apparatus according to Claim 13, wherein the illumination apparatus is used to inspect fresh fish.

15. The illumination apparatus according to Claim 6, 7, 13, or 14, further comprising a lens that controls a propagation direction of the light emitted by the light emitting device.

16. The illumination apparatus according to Claim 15,
wherein, when a distance between the lens and a surface perpendicular to a central axis of the lens is 30 cm,
an irradiation region of the surface, the irradiation region being irradiated with the light emitted by the light emitting device, is a circular region having a diameter that is less than or equal to 10 cm.
